## Europäisches Patentamt

## European Patent Office

## Office européen des brevets

(11) Veröffentlichungsnummer: **0 143 354**
**B1**

(12) **EUROPÄISCHE PATENTSCHRIFT**

(45) Veröffentlichungstag der Patentschrift: **27.12.90**

(51) Int. Cl.⁵: **H 03 M 1/26**

(21) Anmeldenummer: **84113045.3**

(22) Anmeldetag: **30.10.84**

(54) **Mehrstufiger Winkelkodierer.**

(30) Priorität: **26.11.83 DE 3342940**

(43) Veröffentlichungstag der Anmeldung:
**05.06.85 Patentblatt 85/23**

(45) Bekanntmachung des Hinweises auf die
Patenterteilung:
**27.12.90 Patentblatt 90/52**

(84) Benannte Vertragsstaaten:
**AT CH DE FR GB IT LI NL SE**

(56) Entgegenhaltungen:
**US-A-2 779 539**

**PROCESS CONTROL AND AUTOMATION, Band
11, Nr. 3, März 1964, Seite 138; "New digitiser"**

(73) Patentinhaber: **Dr. Johannes Heidenhain GmbH
Dr.-Johannes-Heidenhain-Strasse 5 Postfach
1260
D-8225 Traunreut (DE)**

(72) Erfinder: **Ernst, Alfons, Dipl.-Ing.
Traunring 62
D-8225 Traunreut (DE)**

## Beschreibung

Die Erfindung betrifft einen mehrstufigen Winkelkodierer gemäß dem Oberbegriff des Anspruchs 1.

Mehrstufige Winkelkodierer dienen zur Messung der Winkellage einer Welle über mehrere Umdrehungen, um z.B. die absolute Position eines Schlittens einer Werkzeugmaschine aus der Winkelposition der Antriebsspindel zu bestimmen und sind beispielsweise aus der DE—A—21 26 510 und aus der DE—A—27 46 854 bekannt.

Ein derartiger Winkelkodierer, der einen Winkel $n \cdot 360°$ messen soll, enthält eine erste mit der Welle des Winkelkodierers verbundene Codescheibe, die die absolute Feinposition der Welle in $z$ Schritten innerhalb des Winkels 360° eindeutig kennzeichnet, sowie mindestens eine zweite Codescheibe, die mit der Welle des Winkelkodierers über ein Untersetzungsgetriebe mit der Untersetzung $n$ verbunden ist und die absolute Grobposition der Welle innerhalb des Winkels $n \cdot 360°$ in einem eindeutigen Code kennzeichnet, so daß insgesamt eine Anzahl von $n \cdot z$ Winkelschritten in codierter Form dargestellt ist.

Bei Winkelkodierern werden zur Winkelkodierung vorzugsweise einschrittige Codes verwendet, bei denen sich benachbarte Binärkombinationen stets nur in einer Binärstelle unterscheiden, um keine undefinierten Zwischenzustände beim Übergang von einer Winkelstellung in die nächste Winkelstellung zu erhalten, da solche einschrittigen Codes den geringsten elektronischen Aufwand erfordern. Bei diesen einschrittigen Codes wird aber die Meßgenauigkeit von den Codeinformationen aller Codespuren auf den beiden Codescheiben bestimmt. Die Untersetzungsgetriebe mehrstufiger Winkelkodierer sind im allgemeinen aber zu ungenau, um die Codeinformation der Grobcodescheibe der Codeinformation der Feincodescheibe exakt zuzuordnen. Aus diesem Grund wird üblicherweise die Codeinformation jeder Codespur der Grobcodescheibe doppelt (einmal voreilend und einmal nacheilend) abgetastet; mit Hilfe eines Signals, das von der Feincodescheibe abgeleitet wird, entscheidet eine Schaltlogik, welche Grobcodeinformation ausgewertet werden soll (Prinzip der U-Abtastung). Diese Doppelabtastung ist aber insbesondere bei großen Meßlängen und damit bei vielen Codespuren sehr aufwendig.

Aus der US—A—2,779,539 ist ein mehrstufiger Winkelkodierer mit einer Feincodescheibe bekannt, der eine Grobcodescheibe über ein Untersetzungsgetriebe nachgeschaltet ist. Die Feincodeinformationen der Feincodescheibe und die Grobcodeinformationen der Grobcodescheibe werden jeweils von einem Abtastelement abgetastet und in einer nachgeschalteten logischen Schaltung einander elektrisch überlagert.

In der Druckschrift "Process Control And Automation" Band 11, Nr. 3, März 1964, Seite 138 ist unter "New Digitiser" ein mehrstufiger Winkelkodierer mit einer Feincodescheibe und einer über ein Untersetzungsgetriebe nachgeschalteten Grobcodescheibe beschrieben. Zur Kompensation eines Spiels des Untersetzungsgetriebes überlappen sich die Feincodeinformation und die Grobcodeinformation um einen entsprechenden Betrag.

Der Erfindung liegt die Aufgabe zugrunde, bei einem mehrstufigen Winkelkodierer der oben genannten Gattung eine Einfachabtastung der Codeinformation mit hoher Meßgenauigkeit zu ermöglichen.

Diese Aufgabe wird erfindungsgemäß durch die kennzeichnenden Merkmale des Anspruchs 1 gelöst.

Die mit der Erfindung erzielten Vorteile bestehen insbesondere darin, daß mit einfachen Mitteln eine eindeutige Zuordnung der Grobcodeinformation zur Feincodeinformation erzielt wird, so daß eine aufwendige Doppelabtastung und eine Schaltlogik entfallen können und an die Genauigkeit des Untersetzungsgetriebes keine großen Anforderungen gestellt werden müssen. Insgesamt ergibt sich somit ein einfach aufgebauter und damit preisgünstiger mehrstufiger Winkelkodierer mit hoher Meßgenauigkeit.

Vorteilhafte Weiterbildungen entnimmt man den Unteransprüchen.

Ausführungsbeispiele der Erfindung werden anhand der Zeichnung näher erläutert.

Es zeigen

Figur 1 einen zweistufigen Winkelkoderier,

Figur 2 das Codeschema eines 4-Bit Graycodes,

Figur 3 und 4 zwei Codescheiben mit zugehöriger Abtastplatte und

Figur 5 und 6 schematische Darstellungen der Überlagerung der Codespuren der Grobcodescheibe und der Steuerspuren der Feincodescheibe.

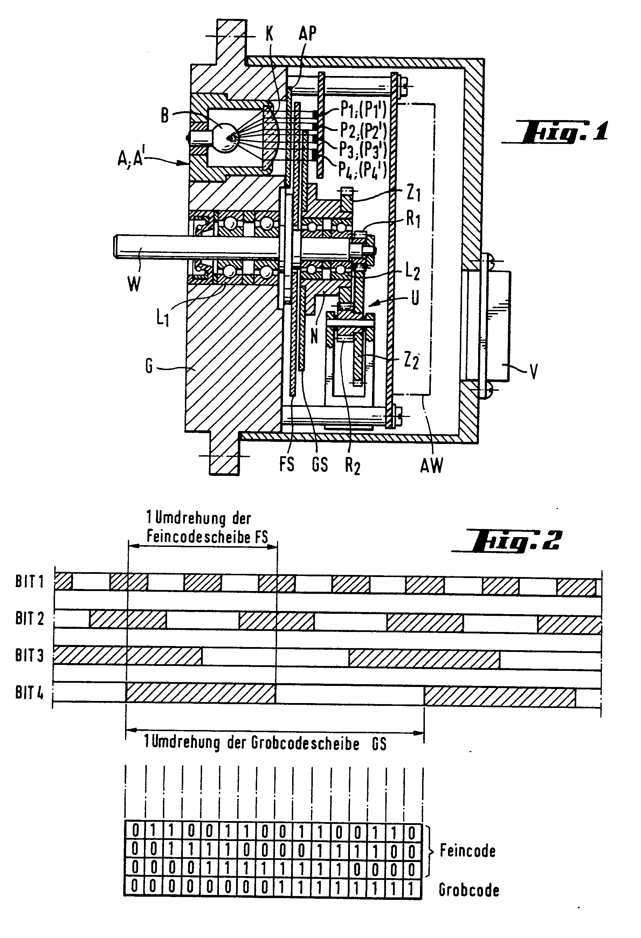

In Figur 1 ist ein zweistufiger Winkelkodierer dargestellt, dessen Gehäuse G mit einem Maschinenteil einer nicht gezeigten Bearbeitungsmaschine verbunden ist. Im Gehäuse G ist mittels Lager $L_1$ eine Welle W gelagert, die über eine Kupplung mit einer Antriebsspindel der Bearbeitungsmaschine verbunden ist. Auf der Welle W sind eine Feincodescheibe FS und ein Ritzel $R_1$ befestigt, das über ein Zahnrad $Z_2$ und ein Ritzel $R_2$ eines im Gehäuse G fest angeordneten Untersetzungsgetriebes U ein mit einer Nabe N verbundenes Zahnrad $Z_1$ antreibt. Die Nabe N ist mittels Lager $L_2$ auf der Welle W gelagert und trägt eine Grobcodescheibe GS, die in geringem Abstand von der Feincodescheibe FS gegenüber dieser mit der halben Winkelgeschwindigkeit infolge der Untersetzung $n=2$ des Untersetzungsgetriebes U drehbar ist.

Zur lichteleketrischen Abtastung der Codeinformationen der Feincodescheibe FS und der Grobcodescheibe GS ist im Gehäuse G eine Abtasteinheit A mit einer Beleuchtungsquelle B, einem Kondensor K, einer Abtastplatte AP und mit Photoelementen $P_1$—$P_4$ befestigt. Die von den Photoelementen $P_1$—$P_4$ erzeugten Abtastsignale werden einer Auswerteeinrichtung AW und über einen Steckverbinder V einer nicht dargestellten digitalen Anzeigeeinheit zugeführt.

In Figur 2 ist das Codeschema eines einschrittigen 4-Bit Graycodes mit einer Tabelle der Binärkombinationen gezeigt. Die dunklen (schraffierten) Felder bedeuten den Binärzustand Null und die hellen Felder den Binärzustand Eins.

Der einschrittige Übergang von einem Binärzustand in den nächsten Binärzustand erfolgt an den Kanten der Felder.

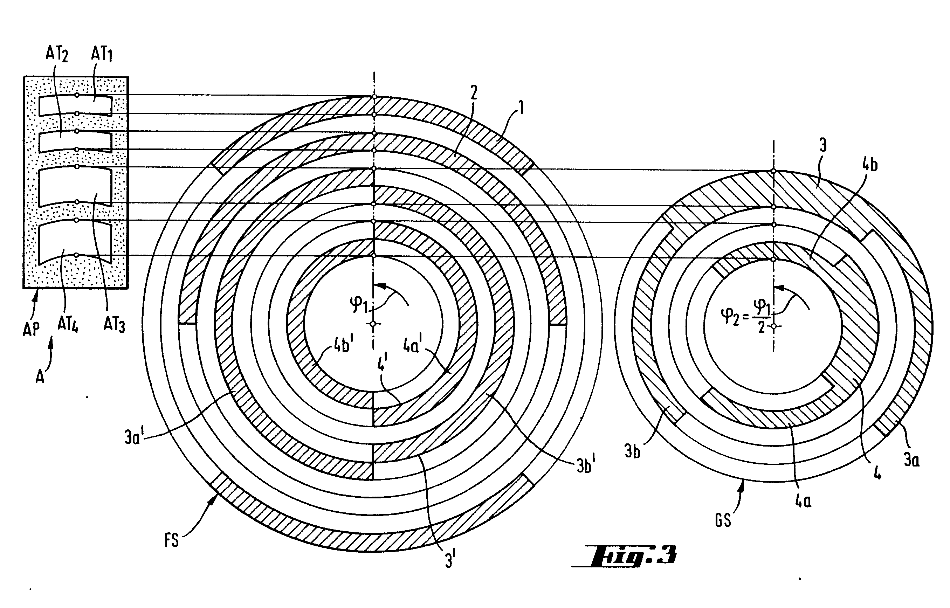

In Figur 3 sind zur Realisierung dieses 4-Bit Graycodes nach Figur 2 bei einem zweistufigen Winkelkodierer mit der Untersetzung n=2 die Feincodescheibe FS und die Grobcodescheibe GS dargestellt. Die Feincodeinformation ist in den Feincodespuren 1, 2 der Feincodescheibe FS und die Grobcodeinformation in den Grobcodespuren 3, 4 der Grobcodescheibe GS enthalten.

Zur eindeutigen Zuordnung der Grobcodeinformation zur Feincodeinformation bei einer Einfachabtastung der Grobcodespuren 3, 4 sind erfindungsgemäß auf der Feincodescheibe FS Steuerinformationen in zwei Steuerspuren 3′, 4′ aufgebracht, die den Grobcodeinformationen der Grobcodespuren 3, 4 der Grobcodescheibe GS direkt überlagert werden. Die Grobcodespuren 3, 4 der Grobcodescheibe GS sind jeweils in zwei konzentrische Grobcodehalbspuren 3a, 3b, 4a, 4b und die Steuerspuren 3′, 4′ der Feincodescheibe FS jeweils in zwei konzentrische Steuerhalbspuren 3a′, 3b′, 4a′, 4b′ aufgeteilt. Zur Abtastung der Feincodespuren 1, 2 der Feincodescheibe FS sind auf der Abtastplatte AP der Abtasteinheit A Abtastfelder $AT_1$, $AT_2$ vorgesehen. Zur gemeinsamen Abtastung der Steuerhalbspuren 3a′, 3b′ der Feincodescheibe FS und der Grobcodehalbspuren 3a, 3b der Grobcodescheibe GS sind auf der Abtastplatte AP ein Abtastfeld $AT_3$ und zur gemeinsamen Abtastung der Steuerhalbspuren 4a′, 4b′ der Feincodescheibe FS und der Grobcodehalbspuren 4a, 4b der Grobcodescheibe GS auf der Abtastplatte AP ein Abtastfeld $AT_4$ vorhanden; den Abtastfeldern $AT_1$—$AT_4$ sind jeweils ein Photoelement $P_1$—$P_4$ in der Abtasteinheit A zugeordnet (Figur 1). Bei Drehung der Feincodescheibe FS um den Winkel $\varphi_1$ dreht sich die Grobcodescheibe GS infolge der Untersetzung n=2 um den Winkel $\varphi_2 = \varphi_1/2$.

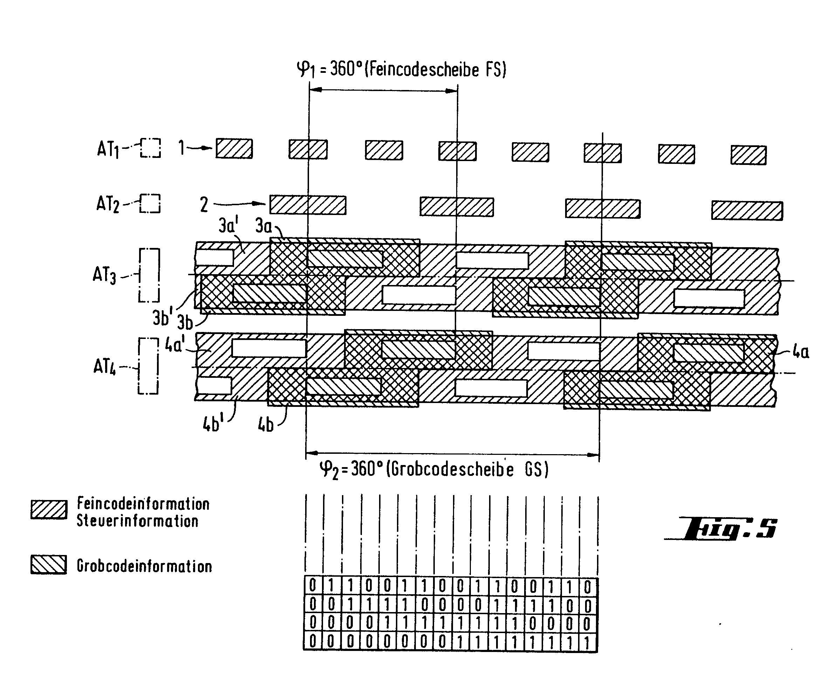

In Figur 5 sind schematisch die Feincodespuren 1, 2 und die Steuerhalbspuren 3a′, 3b′, 4a′, 4b′ der Feincodescheibe FS sowie die Grobcodehalbspuren 3a, 3b, 4a, 4b der Grobcodescheibe GS mit den Abtastfeldern $AT_1$—$AT_4$ und eine Tabelle der Binärkombinationen dargestellt. Zur besseren Kenntlichmachung der Überlagerung der Steuerhalbspuren 3a′, 3b′, 4a′, 4b′ mit den jeweiligen Grobcodehalbspuren 3a, 3b, 4a, 4b sind die Grobcodehalbspuren 3a, 3b, 4a, 4b mit einer größeren Breite dargestellt und weisen eine andere Schraffur auf. Der Binärzustand soll Null sein, wenn die vom Abtastfeld $AT_3$ abgetasteten beiden überlagerten Halbspuren 3a, 3a′ und 3b, 3b′ dunkle (schraffierte) Felder ergeben, und soll Eins sein, wenn wenigstens eine der beiden überlagerten Halbspuren 3a, 3a′ und 3b, 3b′ ein helles Feld ergeben. Diese Binärzustände gelten in gleicher Weise auch für die überlagerten Halbspuren 4a, 4a′ und 4b, 4b′. Die Abtastung der Spuren 1—4 durch die Abtastfelder $AT_1$—$AT_4$ ergeben gemäß der Tabelle die gleichen Binärkombinationen des Graycodes wie in der Tabelle nach Figur 2. Wie ersichtlich, erfolgt der einschrittige Übergang von einem Binärzustand in den nächsten Binärzustand ausschließlich an den Kanten der hellen und dunklen Felder der Steuerinformationen der Steuerhalbspuren 3a′, 3b′, 4a′, 4b′ der Feincodescheibe FS, so daß die Grobcodeinformationen auf den Grobcodehalbspuren 3a, 3b, 4a, 4b relativ zu den Steuerinformationen auf den Steuerhalbspuren 3a′, 3b′, 4a′, 4b′ um maximal 90° verschoben sein können. Für die Untersetzung n=2 des Untersetzungsgetriebes U ist somit ein maximaler Fehler von 90° bezogen auf die Feincodescheibe FS bzw. ein maximaler Fehler von 90°/2 bezogen auf die Grobcodescheibe GS zulässig.

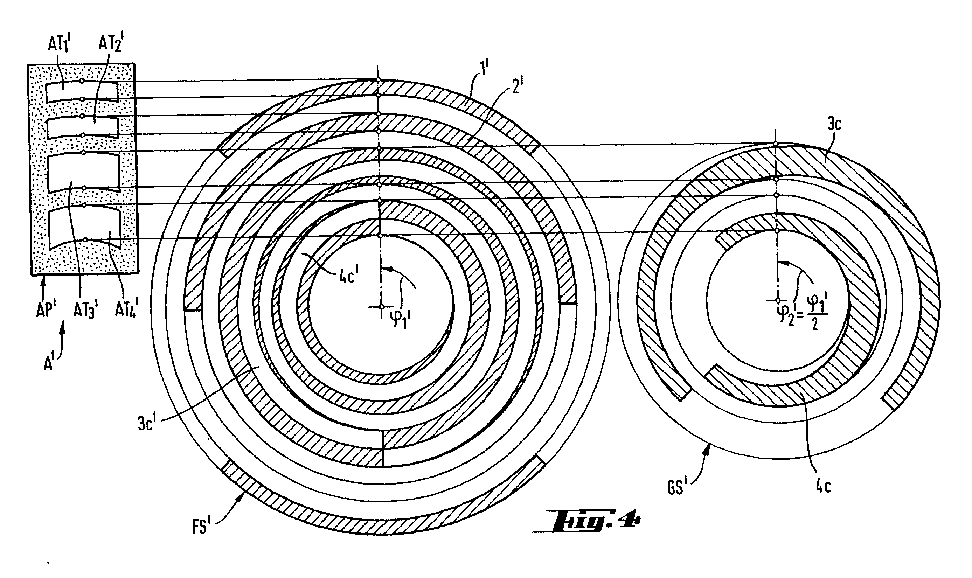

In Figur 4 sind zur Realisierung des 4-Bit Graycodes nach Figur 2 bei einem zweistufigen Winkelcodierer mit der Untersetzung n=2 eine Feincodescheibe FS′ und eine Grobcodescheibe GS′ dargestellt. Die Feincodeinformation ist in den Feincodespuren 1′, 2′ der Feincodescheibe FS′ und die Grobcodeinformation in den Grobcodespuren 3c, 4c der Grobcodescheibe GS′ enthalten.

Zur eindeutigen Zuordnung der Grobcodeinformation zur Feincodeinformation bei einer Einfachabtastung der Grobcodespuren 3c, 4c sind auf der Feincodescheibe FS′ Steuerinformationen in zwei spiralförmigen Steuerspuren 3c′, 4c′ aufgebracht, die den Grobcodeinformationen der ebenfalls spiralförmigen Grobcodespuren 3c, 4c der Grobcodescheibe GS′ direkt überlagert werden. Zur Abtastung der Feincodespuren 1′, 2′ der Feincodescheibe FS′ sind auf einer Abtastplatte AP′ einer Abtasteinheit A′ Abtastfelder $AT_1'$, $AT_2'$ vorgesehen. Zur gemeinsamen Abtastung der Steuerspur 3c′ der Feincodescheibe FS′ und der Grobcodespur 3c der Grobcodescheibe GS′ sind auf der Abtastplatte AP′ ein Abtastfeld $AT_3'$ und zur gemeinsamen Abtastung der Steuerspur 4c′ der Feincodescheibe FS′ und der Grobcodespur 4c der Grobcodescheibe GS′ auf der Abtastplatte AP′ ein Abtastfeld $AT_4'$ vorhanden; den Abtastfeldern $AT_1'$—$AT_4'$ sind jeweils ein Photoelement $P_1'$—$P_4'$ in der Abtasteinheit A′ zugeordnet (Figur 1). Bei Drehung der Feincodescheibe FS′ um den Winkel $\varphi_1'$ dreht sich die Grobcodescheibe GS′ infolge der Untersetzung n=2 um den Winkel $\varphi_2' = \varphi_1'/2$.

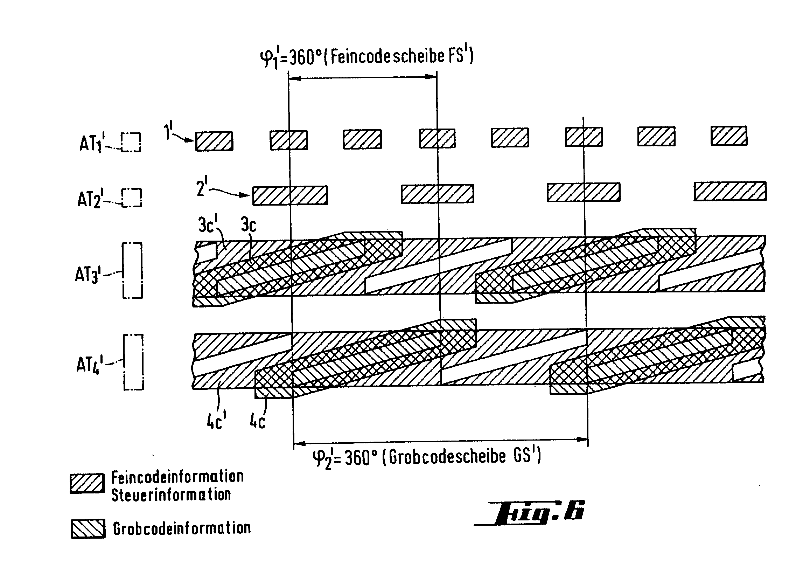

In Figur 6 sind schematisch die Feincodespuren 1′, 2′ und die Steuerspuren 3c′, 4c′ der Feincodescheibe FS′ sowie die Grobcodespuren 3c, 4c der Grobcodescheibe GS′ mit den Abtastfeldern $AT_1'$—$AT_4'$ gemäß Figur 4 dargestellt. Zur besseren Kenntlichmachung der gegenseitigen Überlagerung weisen die Steuerspuren 3c′, 4c′ und die Grobcodespuren 3c, 4c eine unterschiedliche Schraffur auf. Der Binärzustand soll Null sein, wenn die vom Abtastfeld $AT_3'$ abgetasteten beiden überlagerten Spuren 3c, 3c′ dunkle (schraffierte) Felder ergeben, und soll Eins sein, wenn die beiden überlagerten Spuren 3c, 3c′ ein helles Feld ergeben. Diese Binärzustände gelten in gleicher Weise auch für die überlagerten Spuren 4c, 4c'. Die Abtsatung der Spuren 1', 2', 3c, 3c', 4c, 4c' durch die Abtastfelder $AT_1'$—$AT_4'$ ergeben die gleichen Binärkombinationen des Graycodes wie in der Tabelle nach Figur 2. Wie ersichtlich, erfolgt der einschrittige Übergang von einem Binärzustand in den nächsten Binärzustand ausschließlich an den Kanten der hellen und dunklen Felder der Steuerinformationen der Steuerspuren 3c', 4c' der Feincodescheibe FS', so daß die Grobcodeinformatinoen auf den Grobcodespuren 3c, 4c relativ zu den Steuerinformationen auf den Steuerspuren 3c', 4c' um maximal 90° verschoben sein können.

Für die Untersetzung n=2 des Untersetzungsgetriebes U ist somit ein maximaler Fehler von 90° bezogen auf die Feincodescheibe FS' bzw. ein maximaler Fehler von 90°/2 bezogen auf die Grobcodescheibe GS' zulässig.

Die mit einem derartigen Winkelkodierer ermittelten absoluten Meßwerte können sowohl in einer Positionsanzeige als auch in einer numerischen Steuerung weiterverarbeitet werden.

Die Erfindung ist nicht auf lichtelektrische Meßeinrichtungen beschränkt, sondern kann auch bei magnetischen, induktiven oder kapazitiven Meßeinrichtungen eingesetzt werden.

## Patentansprüche

1. Mehrstufiger Winkelkodierer mit einer mit einer Antriebswelle verbundenen Feincodescheibe (FS) und mit wenigstens einer der Feincodescheibe über ein Untersetzungsgetriebe nachgeschalteten Grobcodescheibe (GS), das ein Untersetzungsverhältnis 1:n zur Codierung von n Umdrehungen der Feincodescheibe aufweist, sowie mit einer Abtasteinheit zur Abtastung der Codeinformationen der Codescheiben, dadurch gekennzeichnet, daß zur eindeutigen Zuordnung der Grobcodeinformation zur Feincodeinformation Steuerinformationen auf konzentrischen Steuerspuren (3a', 3b', 4a', 4b') der Feincodescheibe (FS) sowie die Grobcodeinformationen auf konzentrischen Grobcodespuren (3a, 3b, 4a, 4b) der Grobcodescheibe (GS) aufgebracht sind und daß die Steuerinformationen der Feincodescheibe (FS) den Grobcodeinformationen der Grobcodescheibe (GS) durch gemeinsame Abtastung direkt überlagerbar sind.

2. Mehrstufiger Winkelkodierer mit einer mit einer Antriebswelle verbundenen Feincodescheibe (FS) und mit wenigstens einer der Feincodescheibe über ein Untersetzungsgetriebe nachgeschalteten Grobcodescheibe (GS), das ein Untersetzungsverhältnis 1:n zur Codierung von n Umdrehungen der Feincodescheibe aufweist, sowie mit einer Abtasteinheit zur Abtastung der Codeinformationen der Codescheiben, dadurch gekennzeichnet, daß zur eindeutigen Zuordnung der Grobcodeinformation zur Feincodeinformation Steuerinformationen auf spiralförmigen Steuerspuren (3c', 4c') der Feincodescheibe (FS') sowie die Grobcodeinformationen auf spiralförmigen Grobcodespuren (3c, 4c) der Grobcodescheibe (GS') aufgebracht sind und daß die Steuerinformationen der Feincodescheibe (FS') den Grobcodeinformationen der Grobcodescheibe (GS') durch gemeinsame Abtastung direkt überlagerbar sind.

3. Winkelkodierer nach Anspruch 1, dadurch gekennzeichnet, daß die konzentrischen Steuerspuren (3a', 3b', 4a', 4b') der Feincodescheibe (FS) aus jeweils zwei konzentrischen Steuerhalbspuren und die konzentrischen Grobcodespuren (3a, 3b, 4a, 4b) der Grobcodescheibe (GS) aus jeweils zwei konzentrischen Grobcodehalbspuren bestehen.

4. Winkelkodierer nach den Ansprüchen 1 oder 3, dadurch gekennzeichnet, daß zur gemeinsamen Abtastung jeweils zweier überlagerter konzentrischer Halbspuren (3a, 3a', 3b, 3b'; 4a, 4a', 4b, 4b') jeweils ein Abtastelement ($P_3$; $P_4$) vorgesehen ist.

5. Winkelkodierer nach Anspruch 2, dadurch gekennzeichnet, daß zur gemeinsamen Abtastung jeweils zweier überlagerter spiralförmiger Spuren (3c, 3c'; 4c, 4c') jeweils ein Abtastelement ($P_3'$, $P_4'$) vorgesehen ist.

## Revendications

1. Codeur d'angle à plusieurs étages, comportant un disque de codage fin (FS) lié à un arbre d'entraînement et au moins un disque de codage grossier (GS) entraîné par le disque de codage fin par l'intermédiaire d'une transmission réductrice qui présente un rapport de réduction de 1:n pour coder n tours du disque de codage fin, et comportant une unité de lecture pour lire les informations codées des disques de codage, caractérisé par le fait que, pour associer de manière univoque l'information en code grossier à l'information en code fin, des informations de commande sont disposées sur des pistes de commande concentriques (3a', 3b', 4a', 4b') du disque de codage fin (FS) et les informations en code grossier sont disposées sur des pistes de codage grossier concentriques (3a, 3b, 4a, 4b) du disque de codage grossier (GS), et par le fait que les informations de commande du disque de codage fin (FS) sont directement superposables aux informations en code grossier du disque de codage grossier (GS), par lecture commune.

2. Codeur d'angle à plusieurs étages, comportant un disque de codage fin (FS) lié à un arbre d'entraînement et au moins un disque de codage grossier (GS) entraîné par le disque de codage fin par l'intermédiaire d'une transmission réductrice qui présente un rapport de réduction 1:n pour coder n tours du disque de codage fin, et comportant une unité de lecture pour lire les informations codées des disques de codage, caractérisé par le fait que, pour associer de manière univoque l'information en code grossier à l'information en code fin, des informations de commande sont disposées sur des pistes de commande en forme de spirale (3c', 4c') du disque de codage fin (FS') et les informations en code grossier sont disposées sur des pistes de codage grossier en forme de spirale (3c, 4c) du disque de codage grossier (GS'), et par le fait que les informations de commande du disque de codage fin (FS') sont directement superposables aux informations en code grossier du disque de codage grossier (GS'), par lecture commune.

3. Codeur d'angle selon revendication 1, caractérisé par le fait que les pistes de commande concentriques (3a', 3b', 4a', 4b') du disque de codage fin (FS) sont constituées à chaque fois par deux demi-pistes de commande concentriques, et les pistes de codage grossier concentriques (3a, 3b, 4a, 4b) du disque de codage grossier (GS) sont constituées à chaque fois par deux demi-pistes de codage grossier concentriques.

4. Codeur d'angle selon les revendications 1 ou 3, caractérisé par le fait que, pour la lecture commune de deux demi-pistes concentriques superposées (3a, 3a', 3b, 3b'; 4a, 4a', 4b, 4b'), il est prévu à chaque fois un élément de lecture (P$_3$; P$_4$).

5. Codeur d'angle selon revendication 2, caractérisé par le fait que, pour la lecture commune de deux pistes en forme de spirale superposées (3c, 3c'; 4c, 4c'), il est prévu à chaque fois un élément de lecture (P$_3$', P$_4$').

## Claims

1. Multistage angle encoder with a fine coding disc (FS) connected to a drive shaft and with at least one coarse coding disc (GS) connected after the fine coding disc through a reduction gear, which has a reduction ratio 1:n for coding n revolutions of the fine coding disc, as well as with a sensing unit for sensing the coding information of the coding discs, characterized in that, for unambiguous association of the coarse coding information with the fine coding information, control information is laid down on concentric control tracks (3a', 3b', 4a', 4b') of the fine coding disc (FS) as well as the coarse coding information on concentric coarse code tracks (3a, 3b, 4a, 4b) of the coarse coding disc (GS) and in that the control information of the fine coding disc (FS) can be directly superimposed on the coarse coding information of the coarse coding disc (GS) by common sensing.

2. Multistage angle encoder with a fine coding disc (FS) connected to a drive shaft and with at least one coarse coding disc (GS) connected after the fine coding disc through a reduction gear, which has a reduction ratio 1:n for coding n revolutions of the fine coding disc, as well as with a sensing unit for sensing the coding information of the coding discs, characterized in that, for unambiguous association of the coarse coding information with the fine coding information, control information is laid down on spiral control tracks (3c', 4c') of the fine coding disc (FS') as well as the coarse coding information on spiral coarse code tracks (3c, 4c) of the coarse coding disc (GS') and in that the control information of the fine coding disc (FS') can be directly superimposed on the coarse coding information of the coarse coding disc (GS') by common sensing.

3. Angle encoder according to claim 1, characterized in that the concentric control tracks (3a', 3b', 4a', 4b') of the fine coding disc (FS) each consist of two concentric control half tracks and the concentric coarse code tracks (3a, 3b, 4a, 4b) of the coarse coding disc (GS) each consist of two concentric coarse code half tracks.

4. Angle encoder according to claim 1 or 3, characterized in that, for the common sensing of each pair of superimposed concentric half tracks (3a, 3a', 3b, 3b'; 4a, 4a', 4b, 4b') a correspnding sensing element (P$_3$; P$_4$) is provided for each.

5. Angle encoder according to claim 2, characterized in that, for the common sensing of each pair of superimposed spiral half tracks (3c, 3c'; 4c, 4c') a corresponding sensing element (P$_3$'; P$_4$') is provided for each.

**Fig.1**

1 Umdrehung der
Feincodescheibe FS

**Fig.2**

BIT 1

BIT 2

BIT 3

BIT 4

1 Umdrehung der Grobcodescheibe GS

| 0 | 1 | 1 | 0 | 0 | 1 | 1 | 0 | 0 | 1 | 1 | 0 | 0 | 1 | 1 | 0 | } Feincode |
| 0 | 0 | 1 | 1 | 1 | 1 | 0 | 0 | 0 | 0 | 1 | 1 | 1 | 1 | 0 | 0 | |
| 0 | 0 | 0 | 0 | 1 | 1 | 1 | 1 | 1 | 1 | 1 | 1 | 0 | 0 | 0 | 0 | |
| 0 | 0 | 0 | 0 | 0 | 0 | 0 | 0 | 1 | 1 | 1 | 1 | 1 | 1 | 1 | 1 | Grobcode |

1

Fig. 3

AT₂  AT₁

AT₃

AP  AT₄  AT₃

A

2  1

3
4b

$\varphi_1$

$\varphi_2 = \dfrac{\varphi_1}{2}$

4b'  4a'

4'

3b  4a  3a

GS

3a'

FS

3b'

3'

2

EP 0 143 354 B1

Fig. 4

EP 0 143 354 B1

$\varphi_1 = 360°$ (Feincodescheibe FS)

$\varphi_2 = 360°$ (Grobcodescheibe GS)

Feincodeinformation
Steuerinformation

Grobcodeinformation

**Fig. 5**

| 0 | 1 | 1 | 0 | 0 | 1 | 1 | 0 | 0 | 1 | 1 | 0 | 0 | 1 | 1 | 0 |
| 0 | 0 | 1 | 1 | 1 | 1 | 0 | 0 | 0 | 0 | 1 | 1 | 1 | 1 | 0 | 0 |
| 0 | 0 | 0 | 0 | 1 | 1 | 1 | 1 | 1 | 1 | 1 | 1 | 0 | 0 | 0 | 0 |
| 0 | 0 | 0 | 0 | 0 | 0 | 0 | 0 | 1 | 1 | 1 | 1 | 1 | 1 | 1 | 1 |

EP 0 143 354 B1

$\varphi_1' = 360°$ (Feincodescheibe FS')

AT1' $\cdots$ ▫  1' →

AT2' $\cdots$ ▫  2' →

3c' 3c

AT3' $\cdots$ ▯

4c' 4c

AT4' $\cdots$ ▯

$\varphi_2' = 360°$ (Grobcodescheibe GS')

▨ Feincodeinformation
  Steuerinformation

▧ Grobcodeinformation

*Fig. 6*